# EUROPÄISCHE PATENTSCHRIFT

(11) **EP 1 901 429 B1**
(45) Veröffentlichungstag und Bekanntmachung des Hinweises auf die Patenterteilung: **20.04.2011**
(21) Anmeldenummer: 06019177.2
(22) Anmeldetag: 13.09.2006
(51) Int. Cl.: H03K 17/95

(54) **Verfahren und Vorrichtung zur beschleunigten Erkennung eines Auslösefalls eines berührungslosen Schaltsystems**
Method and apparatus for accelerated detection of an event triggering a contactless switching system
Procédé et appareil de détection accélérée d'un événement de déclenchement d'un système de commutation sans contact

(43) Veröffentlichungstag der Anmeldung: 19.03.2008
(73) Patentinhaber: SIEMENS AKTIENGESELLSCHAFT, 80333 München (DE)
(72) Erfinder: Hammer, Christian, 92263 Ebermannsdorf (DE); Metz, Gerhard, 81379 München (DE); Pistor, Klaus, Dr., 85579 Neubiberg (DE); Seisenberger, Claus, 84181 Neufrannhofen (DE)

(56) Entgegenhaltungen:
- WO-A-90/15211
- WO-A-99/16035
- WO-A-2005/106909
- DE-A1- 19 711 588
- DE-U1-202006 001 266

## Beschreibung

Die Erfindung betrifft ein Verfahren zur beschleunigten Erkennung eines Auslösefalls eines berührungslosen Schaltsystems mit wenigstens einem Sensor und wenigstens einem Signalgeber, wobei der Signalgeber mindestens eine Datensequenz sendet und der Sensor die Datensequenz empfängt. Die Erfindung betrifft weiter einen Sensor und ein berührungsloses Schaltsystem zur beschleunigten Erkennung eines Auslösefalls.

Ein Verfahren gemäß Oberbegriff des Anspruchs 1 sowie ein Sensor gemäß Oberbegriff des Anspruchs 11 ist aus Dokument WO 90/15211 bekannt.

Ein derartiges Schaltsystem bzw. ein derartiges Verfahren zur Schaltbereichskontrolle kommt im privaten, sowie im industriellen Bereich zum Einsatz. Das Schaltsystem hat die Funktion, einen Eintritt eines Signalgebers innerhalb eines Wirkbereichs des Schaltsystems zu detektieren und daraufhin das Ereignis beispielsweise zu melden oder einen Ein-, Aus-, oder Schutzschaltvorgang auszulösen. Die Auslösung findet meist dann statt, wenn der Träger des Signalgebers innerhalb des Wirkbereiches oder für einen gewissen Zeitraum innerhalb dieses Wirkbereiches detektiert wird. In der Regel stellt der Träger eine mobile Einheit dar, die mit dem Signalgeber für einen Sensor detektierbar gemacht werden soll.

Beispielsweise ist die Sicherheitstür (Absperrung) einer Presse mit einem derartigen Schaltsystem ausrüstbar, so dass beim Öffnen der Tür, welche einen Signalgeber trägt, sichergestellt ist, dass die Presse keinen Druck erzeugen kann. Das berührungslos wirkende Schaltsystem verhindert folglich die Aktivierung der Presse, solange sich Personen oder Objekte im Gefahrenbereich befinden.

Ein berührungsloses Schaltsystem ist in der Regel als Positions- oder Sicherheitsschalter ausgeführt, der aus mindestens zwei unabhängig beweglichen Teilen, dem Sensor und dem Signalgeber besteht. Der Sensor kommuniziert mit dem Signalgeber, beispielsweise mittels magnetischen bzw. elektromagnetischen Wechselfeldern. Gegebenenfalls auf Anfrage des Sensors hin sendet der Signalgeber eine entsprechende Antwort, die in der Regel eine Seriennummer als Identifikationsnummer und eine Prüfsumme enthält. Die Seriennummer wird in der Regel dazu verwendet, den Signalgeber zu identifizieren und um eventuell signalgeberabhängige Schaltvorgänge auszulösen. Die Prüfsumme hingegen hat die Funktion, die fehlerfreie Datenübertragung zu gewährleisten. Wie bereits beispielhaft beschrieben, ist der Positions- oder Sicherheitsschalter dafür vorgesehen, einen sicherheitsrelevanten Wirkbereich nur dann freizugeben, wenn sich der Signalgeber relativ zum Sensor innerhalb eines definierten Schaltbereichs befindet.

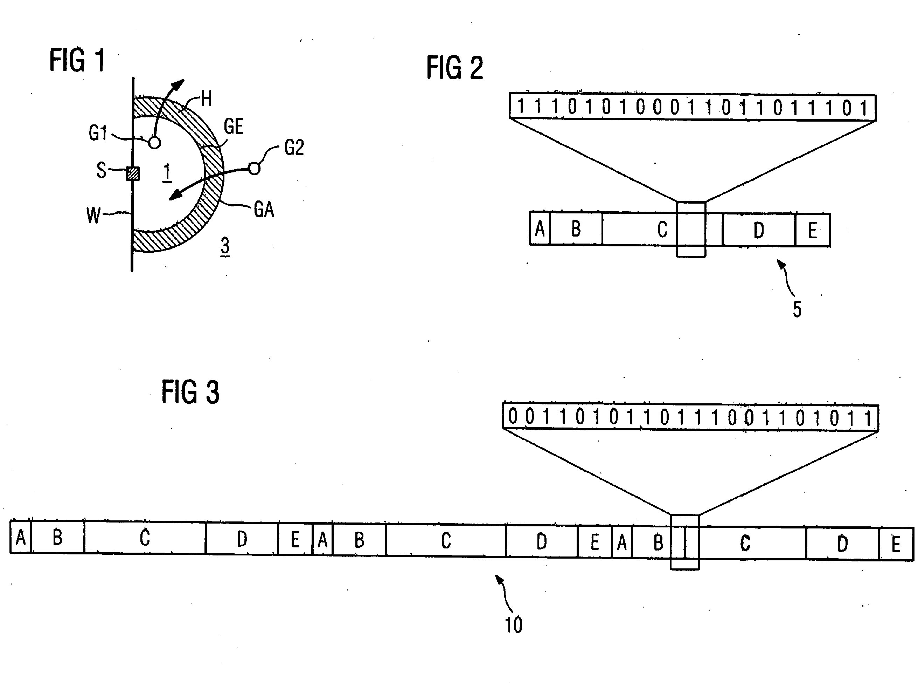

Ein Signalgeber sendet in der Regel sich gegebenenfalls wiederholende, identische Sequenzen. Der Signalgeber kann sowohl für eine wiederholte Sendung der Datensequenz 5 vorgesehen sein, als auch für eine auf Anfrage gesendete Datensequenzantwort. Das Datenformat einer Sequenz besteht üblicherweise aus fünf Teilen, die in FIG 2 aufgezeigt sind. Die Datensequenz 5 beinhaltet fünf Datensegmente A, B, C, D, E. Am Anfang der Datensequenz 5 steht die Startfolge A, die zur Synchronisation des Sensors mit der eintreffenden Datensequenz 5 benötigt wird. Auf die Startfolge A folgt der so genannte Header B, der meist herstellerabhängig ist und gegebenenfalls auch entfallen kann. Nach dem Header B folgt die Seriennummer C, die der eindeutigen Identifikation des Signalgebers dient. Das Datensegment D enthält eine Prüfsumme, die beispielsweise nach dem so genannten "Cyclic Redundancy Check" (CRC)-Verfahren berechnet werden kann. Zuletzt schließt sich der so genannte Trailer E an, auf den die nächste Datensequenz 5 bzw. deren Startfolge A folgt. Die Prüfsumme wird üblicherweise aus dem Header B und der Seriennummer C gebildet, um den fehlerfreien Empfang dieser Datensegmente mit hoher Wahrscheinlichkeit anzuzeigen. Der Sensor errechnet zur Kontrolle eine Prüfsumme aus den Daten der Datensegmente B und C, die anschließend mit der übermittelten Prüfsumme d verglichen wird. Bei Gleichheit ist mit einer hohen Wahrscheinlichkeit von der fehlerfreien Übertragung der Datensegmente B, C und D auszugehen. Hierbei übernimmt der Trailer E eine gewisse Pufferfunktion für den Fall, dass die Summe aus Header B, Seriennummer C und Prüfsumme D auf dem Signalgeber nicht exakt als Sendesymbolmenge einstellbar ist und auf die nächstgrößere Symbol- oder Bitanzahl ausgewichen werden muss.

Das berührungslose Schaltsystem wird zum derzeitigen Stand der Technik dann in die Lage versetzt, eine Auslöseentscheidung zu fällen, wenn mindestens eine Datensequenz korrekt empfangen wird. Nachteilhafterweise bedeutet dies, dass der fehlerfreie Empfang einer Datensequenz stets abgewartet werden muss, bevor eine Schaltfunktion des Schaltsystems, welches als Positions- oder Sicherheitsschalter ausgeführt sein kann, ausgelöst werden kann. Besonders kritisch ist es, wenn sich der Signalgeber in einem Grenzbereich des Wirkbereiches des Sensors befindet und ein Datenempfang nur mit einer gewissen Fehlerdichte erzielt werden kann und der Empfang einer fehlerfreien Datensequenz relativ unwahrscheinlich ist. Folglich ist es entscheidend, dass der Sensor zumindest die Datensegmente von der Seriennummer C bis zur Prüfsumme D fehlerfrei ausliest, um nachweisen zu können, dass der Signalgeber innerhalb des Wirkbereichs des Sensors zu finden ist.
Die Startfolge A und der Trailer E haben beide einen festen Inhalt. Sie können daher ebenfalls in die Prüfung auf Fehlerfreiheit mit einbezogen werden, je nach gewünschter Erkennungssicherheit.

Für den Fall, dass der Signalgeber den Wirkbereich des Sensors verlässt, muss das Schaltsystem innerhalb der Auslösezeit darauf reagieren, zum Beispiel, eine Sperr- oder Freigabefunktion auslösen. Hierzu liest der Sensor jede vom Signalgeber gesendete Datensequenz und prüft diese auf Fehlerfreiheit. Kommt eine Datensequenz nicht oder fehlerbehaftet oder nicht rechtzeitig an, muss angenommen werden, dass der Signalgeber den Wirkbereich des Sensors verlassen hat, worauf der Sensor ein Auslösesignal gibt. Um der meist kurzen Auslösezeit genüge zu tun, muss in Kauf genommen werden, dass wegen eingestreuten Funkstörungen eine oder mehrere Datensequenzen gegebenenfalls nicht mehr fehlerfrei vom Sensor gelesen werden können. Um ein sofortiges Auslösen der Schaltfunktionen zu vermeiden, wird üblicherweise eine Maximalanzahl an fehlerhaften Sequenzen in Abhängigkeit von der Auslösezeit toleriert. Erst nachdem die Maximalanzahl an fehlerhaften Datensequenzen erreicht wird, löst das Schaltsystem eine Schaltfunktion, insbesondere eine Sperrfunktion, aus. Werden trotz Anfrage durch den Sensor keine Datensequenzen mehr empfangen, oder sind mehr Datensequenzen als die zulässige Maximalanzahl hintereinander, fehlerhaft empfangen worden, löst der Sensor aus. In der Praxis ist folglich eine Abwägung zwischen der Auslösesicherheit und der Auslösezeit zu treffen. Allerdings kann die daraus hervorgehende Einstellung der Maximalanzahl an fehlerhaft empfangenen Datensequenzen nur in Einheiten von vollständigen Datensequenzen angegeben werden.

Der Erfindung liegt die Aufgabe zugrunde, ein berührungsloses Schaltsystem mit beschleunigter Erkennung eines Auslösefalls bei gleichzeitiger sicherer Auslösefallerkennung anzugeben.

Diese Aufgabe wird durch ein Verfahren der eingangs genannten Art gelöst, wobei eine Auswerteeinheit aus einer mindestens einmalig fehlerfrei empfangenen Datensequenz einen reproduzierten Datenstrom bildet, und die Auswerteeinheit Daten einer zumindest teilweise empfangenen Datensequenz mit Daten des reproduzierten Datenstromes vergleicht. Diese Aufgabe wird weiter durch einen Sensor und ein berührungsloses Schaltsystem mit den im Anspruch 11 bzw. 17 genannten Merkmalen gelöst.

Der Erfindung liegt zudem die Erkenntnis zugrunde, dass die Sicherheit der Auslösefallerkennung durch eine Verbesserung der Erkennungsgeschwindigkeit eines Auslösefalles nachteilig beeinflusst wird.

Das erfindungsgemäß berührungslose Schaltsystem weist wenigstens einen Sensor und wenigstens einen Signalgeber auf, wobei der Signalgeber mindestens eine Datensequenz sendet, die beispielsweise durch den Sensor angefragt wurde und anschließend durch den Sensor empfangen wird. Das erfindungsgemäße berührungslose Schaltsystem ist nach dem mindestens einmaligen, fehlerfreien Empfangen der Datensequenz in der Lage einen Datenstrom mittels der fehlerfrei empfangenen Datensequenz zu bilden. Die Bildung des Datenstroms kann dabei inhaltlich und/oder zeitsynchron die zu sendenden Datensequenzen abbilden, wodurch ein Vergleich der Daten des reproduzierten Datenstroms mit Daten einer zumindest teilweise empfangenen Datensequenz möglich ist. Das berührungslose Schaltsystem, beispielsweise der Sensor, ist somit der Lage, die zu empfangenden Daten vom Signalgeber mittels des reproduzierten Datenstroms vorauszuberechnen. Bei der Bildung des Datenstroms kann insbesondere auf die Übertragungsweise der Datensequenzen Rücksicht genommen werden. So kann beispielsweise berücksichtigt werden, dass der gesendete Datenstrom, der entsteht, wenn der Sensor eine Datensequenz des Signalgebers abfragt oder ein Datenstrom, der entsteht, wenn der Signalgeber automatisch bzw. kontinuierlich Datensequenzen aussendet, gegebenenfalls eine andere Struktur hat. Sobald der zu empfangende Datenstrom bekannt ist, können beispielsweise bitweise, datensegmentweise, symbolweise und/oder teilweise empfangene Datensequenzen mit den Daten des reproduzierten Datenstroms verglichen werden. Nachdem mindestens einmalig das fehlerfreie Empfangen einer Datensequenz mittels der Prüfsumme und eventuell der Prüfung der unveränderlichen Teile festgestellt wurde, ist die betriebsgemäße Verwendung der Prüfsumme redundant geworden. Dies wird dadurch ermöglicht, dass nachdem der Datenstrom vorausberechnet ist, dem Schaltsystem jede oder zumindest jede relevante zu empfangende Dateneinheit, insbesondere ein einzelnes Bit oder Symbol und dessen Empfangszeitpunkt, bekannt ist.

Eine vorteilhafte Ausführungsform weist einen Sensor auf, der beim Auslösefall die Auslösung einer Schaltfunktion bewerkstelligt. Die Schaltfunktion kann hierbei beispielsweise eine Einschaltung, eine Ausschaltung, eine Sperrschaltung und/oder eine Sicherheitsschaltung beinhalten. Die Schaltfunktion kann somit in flexibler Weise auf die jeweilige Anwendung des berührungslosen Schaltsystems angepasst werden.

Vorteilhafterweise ist es möglich, einen Auslösefall von einer bestimmten Fehlerzahldichte abhängig zu machen. Hierbei wird die Anzahl fehlerhaft empfangener Symbole oder Bits innerhalb einer Prüfmenge bestimmt. Ebenfalls denkbar ist eine Entscheidungsregel, die in Abhängigkeit einer absoluten Anzahl fehlerhaft empfangener Daten anzuwenden ist.

Vorteilhafterweise wird der Datenstrom, der durch das berührungslose Schaltsystem nachgebildet wird, auch nach einem ersten Auslösefall weiter zum Vergleich mit möglichen empfangenen Daten herangezogen. Hierdurch ist es möglich, bei einem Verlassen des Wirkbereichs durch den Signalgeber, einen möglichen Wiedereintritt desselben sehr schnell zu detektieren, da in diesem Fall keine nochmalig fehlerfrei empfangene Datensequenz notwendig ist, um die zu empfangenden Daten vorherzusagen. Deshalb ist es auch möglich, ein mehrfaches Verlassen bzw. Eintreten des Signalgebers in den Wirkbereich des Sensors nachzuvollziehen und ein so genanntes Tracking zu gewährleisten.

Vorteilhafterweise lässt sich eine Auswertungslänge der empfangenen Symbole oder Bits einstellen. Die Auswertungslänge ist hierbei weder an die Länge der Datensequenz, der Datensegmente noch an andere Dateneinheiten gebunden. Hierdurch ist die Auswertungslänge zum Vorteil der Reaktionszeit des Systems reduzierbar.

Weitere vorteilhafte Ausbildungen und bevorzugte Weiterbildungen der Erfindung sind der Figurenbeschreibung der Figuren 1 und 3 und/oder den Unteransprüchen zu entnehmen.

Im Folgenden wird die Erfindung anhand der in den Figuren 1 und 3 dargestellten Ausführungsbeispiele näher beschrieben und erläutert.

Es zeigen:
- FIG 1: eine schematische Darstellung eines Wirkbereiches eines berührungslosen Schaltsystems,
- FIG 2: eine schematische Darstellung einer Datensequenz gemäß dem Stand der Technik und
- FIG 3: eine schematische Darstellung eines reproduzierten Datenstroms.

FIG 1 zeigt eine schematische Darstellung eines Wirkbereiches eines berührungslosen Schaltsystems, das einen Sensor S und zwei Signalgeber G1, G2 aufweist. Des Weiteren sind eine Sensorbezugsfläche W und ein Einschaltbereich 1, ein Hysteresebereich H und ein Ausschaltbereich 3 vorgegeben. Die Grenze GA separiert den Hysteresebereich H vom Ausschaltbereich 3 und die Grenze GE befindet sich zwischen dem Hysteresebereich H und dem Einschaltbereich 1. Die drei Schaltbereiche 1, H, 3 haben halbkreis- bzw. ringförmigen Charakter, der in der Praxis nur in Ausnahmefällen gegeben ist. In der Regel werden durch diverse Randbedingungen die Schaltbereiche in ihrer Form in meist komplizierter Weise abgeändert. Verlässt ein erster Signalgeber G1 den Einschaltbereich 1, tritt er in den Hysteresebereich H ein. Zu diesem Zeitpunkt ist das Schaltsystem im Einschaltzustand. Sobald die Grenze GA vom Hysteresebereich H zum Ausschaltbereich 3 hin überschritten wird, löst das System einen Schaltvorgang aus. Hierbei wird die Grenze GA durch das entsprechende Auslösekriterium bestimmt.

Im Folgenden soll beispielhaft von einem Abbruchkriterium ausgegangen werden, welches das fehlerhafte Empfangen von zwei Datenbits innerhalb einer Prüfmenge (Auswertungslänge) von acht empfangenen Datenbits voraussetzt. Die Verwendung von Datenbits ist ebenfalls beispielhaft zu sehen, zumal die folgende Betrachtung entsprechend auch für Symbole gilt. Unabhängig davon, mit welcher Geschwindigkeit der Signalgeber G1 in den Abschaltbereich 3 eintritt, wird innerhalb der Zeit, die durch das Aussenden der Prüfmenge definiert wird, eine Auslöseentscheidung getroffen. Verlässt der Signalgeber G1 den Hysteresebereich H mit einer hohen Geschwindigkeit, so werden die fehlerhaften Bits innerhalb der empfangenen Prüfmenge unmittelbar nacheinander detektiert und der Auslösefall tritt sofort nach dem zweiten fehlerhaft empfangenen Datenbit ein. Dies ist deshalb der Fall, weil die zugrunde gelegte Prüfmenge bereits sechs Bits vor dem ersten fehlerhaften Datenbit begonnen hat. Mit dem Empfangen des zweiten fehlerhaften Datenbits ist die notwendige Fehlerdichte, die dem Auslösekriterium entspricht, gegeben. Verbleibt der Signalgeber G1 in der Höhe der Grenze GA oder treten nur geringe Störsignale auf, tritt ein weiterer Fehler unter Umständen erst außerhalb der Prüfmenge des ersten Fehlers auf. Wenn zwischen dem ersten fehlerhaft empfangenen Bit und dem zweiten fehlerhaft empfangenen Bit eine Datenmenge von sieben korrekt empfangenen Bits liegt, findet keine Auslösung statt. Vermindert sich diese Anzahl auf sechs korrekt empfangene Bits, so ist die Schwelle der notwendigen Fehlerdichte überschritten, womit ein Auslösefall vorliegt. Als Dateneinheit können anstatt Bits auch Symbole entsprechend eingesetzt werden. Hierbei gilt ein Symbol als fehlerhaft, wenn mindestens ein Datenbit des Symbols fehlerhaft ist.

Da das Schaltsystem in der Lage ist, den reproduzierten Datenstrom beliebig fortzusetzen, kann ein Wiedereintritt des Signalgebers G1 schneller als der Ersteintritt detektiert werden. Hierzu ist ebenfalls ein Eintrittskriterium definierbar. So könnte beispielsweise eine Einschaltung dann erfolgen, wenn mindestens sechs korrekte Datenbits einer Prüfmenge empfangen werden. Damit wird die Grenze GE, die den Hysteresebereich H vom Einschaltbereich 1 trennt, definiert. Da der zu erwartende Datenstrom des Signalgebers G1 bekannt ist, ist keine erneute Detektion mindestens einer fehlerfrei empfangenen Datensequenz notwendig, solange sichergestellt ist, dass der Datenstrom nicht abgerissen ist und der Signalgeber nicht gewechselt wurde.

Bei dem Eintritt eines zweiten Signalgebers G2 in den Einschaltbereich 1 hingegen ist eine einmalige, fehlerfrei empfangene, Datensequenz notwendig, da das Schaltsystem den zweiten Signalgeber bzw. dessen Datensequenz noch nicht kennt. Dies bedeutet, dass bekannte Signalgeber in der Regel schneller als neue Signalgeber erkannt werden.

FIG 2 zeigt eine schematische Darstellung einer Datensequenz 5 eines berührungslosen Schaltsystems gemäß dem Stand der Technik. Wie eingangs beschrieben, besteht eine Datensequenz 5 beispielsweise aus fünf Teilen, wobei jeder Teil einem Datensegment entspricht, der eine eigene Funktion aufweist. Die Datensegmente lauten in der Reihenfolge, in der sie vom Sensor S empfangen werden, Startfolge A, Header B, Seriennummer C, Prüfsumme D und Trailer E. Ein herkömmliches Schaltsystem basiert die Entscheidungskriterien in Abhängigkeit von fehlerfrei bzw. fehlerhaft empfangenen Datensequenzen 5. Folglich kommt es zu den zuvor beschriebenen Nachteilen einer datensequenzbasierten Entscheidungsregel.

FIG 3 zeigt eine schematische Darstellung eines reproduzierten Datenstroms 10, der aus einer einmalig fehlerfrei empfangenen Datensequenz 5 gebildet ist. Der reproduzierte Datenstrom 10 gehört zu einem berührungslosen Schaltsystem, welches mit einem kontinuierlich sendenden Signalgeber in Kontakt steht. Es wurde bereits einmalig eine fehlerfreie Datensequenz 5 empfangen und basierend auf der kontinuierlichen Sendung der Datensequenzen 5, der in FIG 3 abgebildete Datenstrom 10 reproduziert, welcher, der Einfachheit halber, nur teilweise (drei Datensequenzen 5) abgebildet, aber endlos gemäß seiner Periodizität fortsetzbar ist.

Obwohl der endlose Datenstrom in seiner Gesamtheit zu betrachten ist, ist das berührungslose Schaltsystem in der Lage, einen Wechsel von einem Signalgeber zu einem anderen, an einem unterbrochenen, empfangenen Datenstrom und an der geänderten Signalgeberseriennummer, zu erkennen.

Da der zu sendende Datenstrom in diesem Ausführungsbeispiel bis in jedes einzelne Symbol oder Bit bekannt ist, kann jedes einzelne Symbol oder Bit unmittelbar auf Fehler geprüft werden, ohne die weitere Berechnung von Prüfsummen zu verwenden. Verlässt der Signalgeber den zulässigen Wirkbereich des Sensors, kann der Sensor dies bereits an dem ersten, fehlerhaft empfangenen Symbol oder Bit vermuten und muss nicht mehr die umständliche Berücksichtigung kompletter Datensequenzen 5 in Kauf nehmen. Dadurch kann der Sensor deutlich schneller reagieren und die maximale Auslösezeit des Systems lässt sich reduzieren.

Als Auslösebedingung für den Signalgebereintritt in den Wirkbereich bzw. den Signalgeberaustritt aus dem Wirkbereich lässt sich eine beliebige Kombination aus fehlerhaft und fehlerfrei empfangenen Symbolen oder Bits definieren. Die Datensequenz oder Datensequenzunterteilungen müssen dabei nicht beachtet werden. Die frei definierbaren Symbol- oder Bitanzahlen der Auslösebedingung hängen also zum Beispiel nicht von der Länge der Seriennummer C oder der Prüfsumme D ab.

Für den Benutzer des berührungslosen Schaltsystems ergeben sich unter anderem die folgenden Vorteile:
a) unabhängig von der Datensequenz des Signalgebers können die Auslösebedingung oder die Freigabebedingung des Positions- oder Sicherheitsschalters symbol- oder bitgenau eingestellt werden;
b) die Auflösung, mit der die Auslöse- und Freigabebedingung und die zugehörigen Auftrittswahrscheinlichkeiten eingestellt werden können, erhöht sich von Sequenz- oder Datenblockebene auf Symbol- oder Bitebene;
c) die Auslöse- und Freigabezeit lässt sich deutlich reduzieren;
d) eine Längenänderung in einem oder mehreren Teilen der Datensequenz 5 des Signalgebers (Datensegmente) zieht keine Änderung der Auslöse- oder Freigabebedingung und deren Auftrittswahrscheinlichkeiten nach sich.

Des Weiteren erweist sich das berührungslose Schaltsystem als äußerst flexibel hinsichtlich der Auslöse- bzw. erneuten Freigabebedingung, die je nach Anforderung, Störsicherheit und Auftrittswahrscheinlichkeiten aus einer Kombination von mehreren Bedingungen mit einer Granularität auf Symbol- oder Bitebene bestehen. Um gegenüber Funkstörsignalen, die nicht unmittelbar eine Auslösung zur Folge haben sollen, robuster zu werden, wird die Auslösebedingung gemäß der Erfindung wie folgt definiert: m Symbole/Bits müssen mindestens in einer zusammenhängenden Folge von n Symbolen/Bits fehlerhaft empfangen worden sein. Nach einer anschließenden Pause von r nichtbeachteten Symbolen/Bits müssen wiederum mindestens s Symbole/Bits in einer zusammenhängenden Folge von t Symbolen/Bits fehlerhaft ankommen. Erst wenn beide Teilbedingungen gleichzeitig erfüllt sind, wird eine Schaltfunktion, wie zum Beispiel eine Sperrfunktion, ausgelöst. In diesem Beispiel kann eine Störung, die n+r Symbole/Bits andauert, toleriert werden. Dauert sie länger an und werden in dem zweiten Abschnitt t mindestens s Symbole/Bits fehlerhaft empfangen, löst das berührungslose Schaltsystem beispielsweise eine Sperrfunktion aus.

Im Folgenden werden die Auslösebedingungen anhand von Bitfolgen veranschaulicht. Diese Betrachtung ist analog auch mit Symbolfolgen durchführbar, ohne dass es im Einzelfall eines entsprechenden Hinweises bedarf.

An einer willkürlich aus dem reproduzierten Datenstrom 10 entnommenen Bitfolge soll im Folgenden die Kombination der Auslösebedingungen veranschaulicht werden. Hierzu ist in FIG 3 dem reproduzierten Datenstrom 10 eine Bitfolge entnommen, die das berührungslose Schaltsystem vom Signalgeber erwartet. In diesem Beispiel ist die Bitfolge teilweise aus dem Datensegment B und teilweise aus dem Datensegment C einer Datensequenz 5 entnommen. Die in der FIG 3 angegebene Bitfolge von Nullen und Einsen entspricht der Bitfolge, die vom berührungslosen Schaltsystem erwartet wird:
00 1101 0110 1110 0110 1011

Geht man beispielsweise von den Werten m = 2, n = 4, r = 8, t = 5 und s = 1 aus, so würde die folgende fehlerhafte Bitfolge an der gezeigten Stelle einen Auslösefall hervorrufen (fehlerhafte Bits unterstrichen), wenn man davon ausgeht, dass mit dem ersten fehlerhaften Bit (n = 1) die Prüfmenge beginnt:
00 1111 0010 1000 0110 1001
wohingegen bei der empfangenen Bitfolge
01 1101 0110 1111 1110 1011
und ebenso bei der empfangenen Bitfolge
00 1010 0001 0001 1110 1011
kein Auslösefall vorliegt. Falls erforderlich, kann der Signalgeber durch eine kurze Abschaltung des magnetischen oder elektromagnetischen Wechselfeldes zurückgesetzt werden. Dies kann an jeder Stelle des gesendeten Datenstroms passieren. Ist die Unterbrechung kurz genug, kann davon ausgegangen werden, dass der Signalgeber nicht gewechselt wurde. Somit geht die Datensynchronität nicht verloren und der Sensor ist in der Lage, bereits bei dem ersten gültig ankommenden Bit eine Fehlererkennung durchzuführen.

Eine entsprechende Verfahrensweise zur beschleunigten Erkennung ist auch auf der Basis von Symbolen anstatt von Bits realisierbar.

Prinzipiell ist das beschriebene Verfahren bei beliebiger Fehlerdichte durchführbar. In der Praxis sind 1 bis 4 fehlerhafte Bits/Symbole von 32 Bits/Symbolen typisch.

## Patentansprüche

1. Verfahren zur beschleunigten Erkennung eines Auslösefalls eines berührungslosen Schaltsystems mit wenigstens einem Sensor (S) und.wenigstens einem Signalgeber (G1, G2), wobei der Signalgeber (G1, G2) mindestens eine Datensequenz (5) sendet und der Sensor (S) die Datensequenz (5) empfängt, **dadurch gekennzeichnet, dass**
- eine Auswerteeinheit aus einer mindestens einmalig fehlerfrei empfangenen Datensequenz (5) einen reproduzierten Datenstrom (10) bildet, und dass
- die Auswerteeinheit Daten einer zumindest teilweise empfangenen Datensequenz (5) mit Daten des reproduzierten Datenstromes (10) vergleicht, wobei eine Schaltfunktion ausgelöst wird, wenn m Symbole/Bits in einer zusammenhängenden Folge von n Symbolen/Bits fehlerhaft empfangen worden sind und nach einer anschließenden Pause von r nichtbeachteten Symbolen/Bits wiederum mindestens s Symbole/Bits in einer zusammenhängenden Folge von t Symbolen/Bits fehlerhaft ankommen.

2. Verfahren nach Anspruch 1, wobei die Auswerteeinheit einen zu empfangenden Datenstrom zumindest teilweise mit dem reproduzierten Datenstrom (10) nachbildet.

3. Verfahren nach einem der Ansprüche 1 oder 2, wobei die Auswerteeinheit des Sensors (S) den zu empfangenden Datenstrom mit einem anhand der fehlerfrei empfangenen Datensequenz (5) reproduzierten Datenstrom (10) zumindest teilweise vergleicht.

4. Verfahren nach einem der vorhergehenden Ansprüche, wobei die Auswerteeinheit des Sensors (S) den zu empfangenden Datenstrom zumindest teilweise inhaltlich und/oder synchron nachbildet.

5. Verfahren nach einem der vorhergehenden Ansprüche, wobei der Sensor (S) Mittel zur Auslösung aufweist, die beim Auslösefall eine Schaltfunktion einleiten.

6. Verfahren nach Anspruch 5, wobei die Schaltfunktion mindestens eine Einschaltung, eine Ausschaltung oder eine Schutzschaltung aufweist.

7. Verfahren nach einem der vorhergehenden Ansprüche, wobei der Signalgeber (G1, G2) und/oder der Sensor (S) bewegt wird.

8. Verfahren nach einem der vorhergehenden Ansprüche, wobei der Signalgeber (G1, G2) an einen mobilen Träger anbringbar ist oder angebracht ist.

9. Verfahren nach einem der vorhergehenden Ansprüche, wobei der Signalgeber (G1, G2) auf Anfrage durch den Sensor (S) und/oder zumindest teilweise kontinuierlich mindestens eine Datensequenz (5) sendet.

10. Verfahren nach einem der vorhergehenden Ansprüche, wobei die Auswerteeinheit des Sensors (S) nach dem Empfangen eines ersten fehlerhaften Symbols oder Bits, einer Mehrzahl fehlerhafter Symbole oder Bits oder von Daten mit einer Fehlerzahldichte einen Auslösefall erkennt.

11. Sensor (S) zur beschleunigten Erkennung eines Auslösefalls eines berührungslosen Schaltsystems mit wenigstens einem Signalgeber (G1, G2), wobei der Sensor (S) zum Empfangen mindestens einer vom Signalgeber (G1, G2) gesendeten Datensequenz (5) vorgesehen ist, **dadurch gekennzeichnet, dass** der Sensor (S) eine Auswerteeinheit aufweist, wobei
- die Auswerteeinheit zum Bilden eines reproduzierten Datenstromes (10) aus einer mindestens einmalig fehlerfrei empfangenen Datensequenz (5) vorgesehen ist, und
- die Auswerteeinheit zum Vergleich von Daten einer zumindest teilweise empfangenen Datensequenz (5) mit Daten des reproduzierten Datenstromes (10) vorgesehen ist, wobei die Auslösung einer Schaltfunktion vorgesehen ist, wenn m Symbole/Bits in einer zusammenhängenden Folge von n Symbolen/Bits fehlerhaft empfangen worden sind und nach einer anschließenden Pause von r nichtbeachteten Symbolen/Bits wiederum mindestens s Symbole/Bits in einer zusammenhängenden Folge von t Symbolen/Bits fehlerhaft ankommen.

12. Sensor (S) nach Anspruch 11, wobei die Auswerteeinheit des Sensors (S) zur zumindest teilweisen Nachbildung eines empfangenen Datenstroms aus dem reproduzierten Datenstrom (10) vorgesehen ist.

13. Sensor (S) nach einem der Ansprüche 11 oder 12, wobei der Sensor (S) zur inhaltlichen und/oder zeitsynchronen Nachbildung des empfangenen Datenstroms mittels des reproduzierten Datenstroms (10) vorgesehen ist.

14. Sensor (S) nach einem der Ansprüche 11 bis 13, wobei der Sensor (S) beim Auslösefall zur Auslösung einer Schaltfunktion vorgesehen ist.

15. Sensor (S) nach Anspruch 14, wobei die Schaltfunktion mindestens eine Einschaltung, eine Abschaltung oder eine Schutzschaltung aufweist.

16. Sensor (S) nach einem der Ansprüche 11 bis 15, wobei der Sensor (S) zur Erkennung eines Auslösefalls nach dem Empfangen eines ersten fehlerhaften Symbols oder Bits, einer Mehrzahl fehlerhafter Symbole oder Bits oder von Daten mit einer bestimmten Fehlerzahldichte vorgesehen ist.

17. Berührungsloses Schaltsystem mit beschleunigter Erkennung eines Auslösefalls, wobei das Schaltsystem wenigstens einen Sensor (S) nach Anspruch 11 und wenigstens einen Signalgeber (G1, G2) aufweist und wobei der Signalgeber (G1, G2) zum Senden der Datensequenzen (5) vorgesehen ist.

18. Berührungsloses Schaltsystem nach Anspruch 17, wobei der Signalgeber (G1, G2) zum zumindest teilweise kontinuierlichen Senden und/oder auf Anfrage des Sensors (S) hin zum Senden mindestens einer Datensequenz (5) vorgesehen ist.

## Claims

1. Method for accelerated detection of an event triggering a contactless switching system with at least one sensor (S) and at least one signal generator (G1, G2), with the signal generator (G1, G2) sending at least one data sequence (5) and the sensor (S) receiving the data sequence (5),
**characterised in that**
- an evaluation unit forms a reproduced data stream (10) from a data sequence (5) received at least once without errors, and that
- the evaluation unit compares data of an at least partly received data sequence (5) with data of the reproduced data stream, with a switching function being triggered if at least m symbols/bits in a contiguous sequence of n symbols/bits have been received incorrectly and, after a subsequent pause of r ignored symbols/bits, if once again s symbols/bits arrive incorrectly in a contiguous sequence of t symbols/bits.

2. Method according to claim 1, with the evaluation unit simulating a data stream to be received at least partly with the reproduced data stream (10).

3. Method according to one of claims 1 or 2, with the evaluation unit of the sensor (S) at least partly comparing the data stream to be received with a data stream (10) reproduced on the basis of the data sequence (5) received without errors.

4. Method according to one of the previous claims, with the evaluation unit of the sensor (S) simulating the data stream to be received at least partly in content and/or synchronously.

5. Method according to one of the previous claims, with the sensor having means for triggering, which initiates a switching function for a triggering event.

6. Method according to claim 5, with the switching function comprising at least switching on, switching off or protection switching.

7. Method according to one of the previous claims, with the signal generator (G1, G2) and/or the sensor (S) being moved.

8. Method according to one of the previous claims, with the signal generator (G1, G2) able to be attached or being attached to a mobile support.

9. Method according to one of the previous claims, with the signal generator (G1, G2) sending at least one data sequence (5) at the request of the sensor (S) and/or at least partly continuously.

10. Method according to one of the previous claims, with the evaluation unit of the sensor (S) detecting a trigger event after receiving a first incorrect symbol or bit, a plurality of incorrect symbols or bits or data with an error number density.

11. Sensor (S) for accelerated detection of an event triggering a contactless switching system with at least one signal generator (G1, G2), with the sensor (S) being designed for receiving at least one data sequence (5) sent by the signal generator (G1, G2), **characterised in that** the sensor (S) has an evaluation unit, with
- the evaluation unit being designed to form a reproduced data stream (10) from a data sequence (5) received at least once without errors, and
- the evaluation unit being designed to compare data of an at least partly received data sequence (5) with data of the reproduced data stream (10), with there being provision for the triggering of a switching function if m symbols/bits in a contiguous sequence of n symbols/bits have been received incorrectly and, after a subsequent pause of r ignored symbols/bits, once again at least s symbols/bits arrive incorrectly in a contiguous sequence of t symbols/bits.

12. Sensor (S) according to claim 11, with the evaluation unit of the sensor (S) being designed to at least partly simulate a received data stream from the reproduced data stream (10).

13. Sensor (S) according to one of claims 11 or 12, with the sensor (S) being designed to simulate the contents and/or for time-synchronous simulation of the received data stream by means of the reproducible data stream (10).

14. Sensor (S) according to one of claims 11 to 13, with the sensor (S) being designed to trigger a switching function in the event of triggering.

15. Sensor (S) as claimed in claim 14, with the switching function featuring at least a switching on, switching off or protection switching function.

16. Sensor (S) according to one of claims 11 to 15, with the sensor (S) being designed to detect a triggering event after receiving a first incorrect symbol or bit, a plurality of incorrect symbols or bits or data with a specific error number density.

17. Contactless switching system with accelerated detection of a triggering event, with the switching system having at least one sensor (S) according to claim 11 and at least one signal generator (G1, G2), with the signal generator (G1, G2) being designed for sending the data sequences (5).

18. Contactless switching system according to claim 17, with the signal generator (G1, G2) being designed for at least partly continuous sending and/or, in response to a request from the sensor (S), sending at least one data sequence (5).

## Revendications

1. Procédé de détection accélérée d'un événement de déclenchement d'un système de commutation sans contact comprenant au moins un capteur (S) et au moins un émetteur de signaux (G1, G2), ledit émetteur de signaux (G1, G2) émettant au moins une séquence de données (5) et ledit capteur (S) recevant la séquence de données (5), **caractérisé en ce que**
- une unité d'évaluation forme un flux de données reproduit (10) à partir d'une séquence de données (5) reçue au moins une fois sans erreurs, et **en ce que**
- ladite unité d'évaluation compare des données d'une séquence de données (5) reçue au moins en partie avec des données du flux de données reproduit (10), une fonction de commutation étant déclenchée si m symboles/bits ont été reçus de manière erronée en une suite cohérente de n symboles/bits et qu'ensuite, après une pause de r symboles/bits négligés, au moins s symboles/bits arrivent à nouveau de manière erronée en une suite cohérente de t symboles/bits.

2. Procédé selon la revendication 1, ladite unité d'évaluation simulant au moins en partie un flux de données à recevoir au moyen du flux de données reproduit (10).

3. Procédé selon l'une des revendications 1 et 2, ladite unité d'évaluation du capteur (S) comparant au moins en partie le flux de données à recevoir avec un flux de données (10) reproduit à l'aide de la séquence de données (5) reçue sans erreurs.

4. Procédé selon l'une des revendications précédentes, ladite unité d'évaluation du capteur (S) simulant au moins en partie le flux de données à recevoir en termes de contenu et/ou de synchronisation.

5. Procédé selon l'une des revendications précédentes, ledit capteur (S) comprenant des moyens de déclenchement qui lors dudit événement de déclenchement déclenchent une fonction de commutation.

6. Procédé selon la revendication 5, ladite fonction de commutation comprenant au moins une mise sous tension, une mise hors tension ou une commutation de protection.

7. Procédé selon l'une des revendications précédentes, ledit émetteur de signaux (G1, G2) et/ou ledit capteur (S) étant déplacé (s).

8. Procédé selon l'une des revendications précédentes, ledit émetteur de signaux (G1, G2) pouvant être monté, ou étant monté sur un support mobile.

9. Procédé selon l'une des revendications précédentes, ledit émetteur de signaux (G1, G2) émettant, à la demande du capteur (S) et/ou au moins en partie en continu, au moins une séquence de données (5).

10. Procédé selon l'une des revendications précédentes, ladite unité d'évaluation du capteur (S) détectant un événement de déclenchement après avoir reçu un premier symbole ou bit erroné, une pluralité de symboles ou bits erronés ou des données avec une densité d'erreurs.

11. Capteur (S) de détection accélérée d'un événement de déclenchement d'un système de commutation sans contact comprenant au moins un émetteur de signaux (G1, G2), ledit capteur (S) étant prévu pour recevoir au moins une séquence de données (5) émise par l'émetteur de signaux (G1, G2), **caractérisé en ce que** le capteur (S) comprend une unité d'évaluation,
- ladite unité d'évaluation étant prévue pour former un flux de données reproduit (10) à partir d'une séquence de données (5) reçue au moins une fois sans erreurs, et
- ladite unité d'évaluation étant prévue pour comparer des données d'une séquence de données (5) reçue au moins en partie, avec des données du flux de données reproduit (10), le déclenchement d'une fonction de commutation étant prévu si m symboles/bits ont été reçus de manière erronée en une suite cohérente de n symboles/bits et qu'ensuite, après une pause de r symboles/bits négligés, au moins s symboles/bits arrivent à nouveau de manière erronée en une suite cohérente de t symboles/bits.

12. Capteur (S) selon la revendication 11, ladite unité d'évaluation dudit capteur (S) étant prévue pour simuler au moins en partie un flux de données reçu à partir du flux de données reproduit (10).

13. Capteur (S) selon l'une des revendications 11 et 12, ledit capteur (S) étant prévu pour simuler le flux de données reçu en termes de contenu et/ou de synchronisation au moyen du flux de données reproduit (10).

14. Capteur (S) selon l'une des revendications 11 à 13, ledit capteur (S) étant prévu pour déclencher lors dudit événement de déclenchement une fonction de commutation.

15. Capteur (S) selon la revendication 14, ladite fonction de commutation comprenant au moins une mise sous tension, une mise hors tension ou une commutation de protection.

16. Capteur (S) selon l'une des revendications 11 à 15, ledit capteur (S) étant prévu pour détecter un événement de déclenchement après avoir reçu un premier symbole ou bit erroné, une pluralité de symboles ou bits erronés ou des données avec une densité d'erreurs déterminée.

17. Système de commutation sans contact avec détection accélérée d'un événement de déclenchement, ledit système de commutation comprenant au moins un capteur (S) selon la revendication 11 et au moins un émetteur de signaux (G1, G2), et ledit émetteur de signaux (G1, G2) étant prévu pour émettre les séquences de données (5).

18. Système de commutation sans contact selon la revendication 17, ledit émetteur de signaux (G1, G2) étant prévu pour émettre, au moins en partie de manière continue et/ou à la demande du capteur (S), au moins une séquence de données (5).
